# EUROPÄISCHE PATENTSCHRIFT

(11) **EP 2 297 619 B1**
(45) Veröffentlichungstag und Bekanntmachung des Hinweises auf die Patenterteilung: **03.11.2021**
(21) Anmeldenummer: 09768971.5
(22) Anmeldetag: 23.06.2009
(51) Int. Cl.: G05B 19/042, G05B 9/02, G06F 17/40

(54) **ÜBERWACHUNGSSYSTEM**
MONITORING SYSTEM
SYSTÈME DE SURVEILLANCE

(30) Priorität: 26.06.2008 DE 102008029948
(43) Veröffentlichungstag der Anmeldung: 23.03.2011
(73) Patentinhaber: Phoenix Contact GmbH & Co. KG, 32825 Blomberg (DE)
(72) Erfinder: KORREK, Andre, 37696 Marienmünster (DE)
(74) Vertreter: Bill, Burkart Hartmut
(86) Internationale Anmeldenummer: PCT/EP2009/004516
(87) Internationale Veröffentlichungsnummer: WO 2009/156122

(56) Entgegenhaltungen:
- EP-A- 1 128 241
- EP-A- 1 927 914
- WO-A-2007/124942
- WO-A-2008/037495
- DE-A1-102006 001 805
- US-B1- 6 243 629

## Beschreibung

Die Erfindung betrifft ein Überwachungssystem zur Überwachung sicherheitsrelevanter Prozesse.

Das Dokument EP 1 128 241 A2 offenbart ein Verfahren und eine Vorrichtung zur Sicherheitsüberwachung einer Steuereinrichtung.

Das Dokument WO 2008/037495 A2 beschreibt ein Bussystem mit einem Bus, an welchen wenigstens ein Master, ein Ausgangsslave und ein Sicherheitsmonitor angeschlossen sind, wobei der Ausgangsslave einen Ausgangsschalter und der Sicherheitsmonitor einen Hauptschalter steuern.

Das Dokument DE 10 2006 001 805 A1 offenbart eine Sicherheitsvorrichtung zum mehrkanaligen Steuern einer sicherheitstechnischen Einrichtung.

Das Dokument US 6,243,629 B1 offenbart eine elektrische Steuereinheit für ein Kraftfahrzeug mit einem Mikroprozessor, einem mit diesem verbundenen externen Sensor, einem Stellglied und einer Überwachungseinrichtung. Der Mikroprozessor verarbeitet Informationen vom externen Sensor auf Basis eines im Mikroprozessor gespeicherten Programms und erhält Prüfdaten zum Prüfen des Betriebs des Mikroprozessors von der Überwachungseinrichtung. Die Überwachungseinrichtung ermittelt anhand der Prüfdaten Lösungen, die mit den vom Mikroprozessor zugesandten verarbeiteten Daten. Bei fehlender Übereinstimmung wird eine ODER-Schaltung angewiesen, ein Ausfallsicherungsrelais zu aktivieren, welches die Stromversorgung eines Magnetventils unterbindet.

Ein industrielles, bei Datenübertragungssystemen eingesetztes Kommunikationssystem, das eine Vielzahl von angeschlossene Feldgeräte, wie Messfühler (Sensoren), Stellglieder und/oder Antriebe (Aktoren) mit einer Steuerungseinrichtung verbindet, ist bekanntermaßen ein Feldbus, wobei die Einrichtungen, welche die tatsächliche Verbindung zum Bus bereitstellen, als Bus-Teilnehmer bezeichnet werden.

Bei einer Vielzahl von Applikationen ist hierbei die Deterministik, also die Vorbestimmtheit und Unabänderlichkeit bei der Übertragung von Prozessdaten wichtiger als die eigentliche Übertragungsgeschwindigkeit selbst. Bekannt sind beispielsweise Feldbusse mit daran angeschalteten Teilnehmern, bei welchen zum Übertragen von Prozessdaten zwischen einzelnen Teilnehmern, und also zum Senden und Empfangen von Prozessdaten, wie insbesondere Prozesseingangsdaten, Prozessausgangsdaten und Steuerungsdaten, eine zyklische Übertragung von Prozessdaten über einen gemeinsamen Übertragungskanal durchgeführt wird. Hierzu werden häufig während vorbestimmter Datenzyklen durch einen als Master fungierenden Teilnehmer protokollspezifische Daten von an Slave-Teilnehmern angeschlossenen Feldgeräten ausgelesen und während jeweils nachfolgender Datenzyklen in an Slave-Teilnehmer angeschlossene Feldgeräte hineingeschrieben.

Bei vielen Systemanwendungen sind die zu übertragenen Daten darüber hinaus zumindest teilweise sicherheitsrelevante Daten, so dass Fehler bei der Datenübertragung frühest möglichst erkannt werden müssen und bei Erkennen eines Fehlers zeitnah reagiert, z.B. ein Feldgerät, ein Teilnehmer oder ein (Teil-) System in einen sicheren Zustand überführt werden muss. Bei einer Übertragung sicherheitsrelevanter Daten über einen Bus sind im Wesentlichen sechs Fehlerklassen zu berücksichtigen. Diese betreffen die Wiederholung, den Verlust, die Einfügung, die falsche Abfolge, die Zerstörung und die Verzögerung von sicherheitsrelevanten Daten. Die Übertragung dieser Daten muss somit sicher sein.

Um eine sichere Übertragung von Daten, insbesondere von sicherheitsrelevanten Prozessdaten, zumindest derart zu gewährleisten, dass die aufgeführten Fehlerklassen bei Vorliegen auch erkannt werden können, ist es grundsätzlich gängige Praxis, die übertragenen Daten mit zusätzlichen Kontrolldaten, wie beispielsweise Zeitstempel, Teilnehmerinformation und/oder Checkinformation, z.B. CRCs (Cycle Redundancy Check) zu erweitern. Ein entscheidender Nachteil hierbei ist jedoch, dass der zu übertragende Overhead gegenüber den zu übertragenden Nutzdaten stark ansteigt und dadurch die Protokolleffizienz abnimmt. Besonders eklatant wird diese Schwäche, wenn nur wenige und/oder nur selten sicherheitsrelevante Nutzdaten pro Teilnehmer übertragen werden müssen. Ein weiterer Nachteil bisher bekannter Überwachungssysteme für sicherheitstechnische Daten liegt darin, dass zur Realisierung von teilnehmerspezifischen Prozessen mit sicherheitsgerichteten Ausgängen stets zumindest zwei Mikrocontroller bzw. komplexe Hardwareschaltungen zur Abarbeitung von komplexen Protokollpflichten notwendig sind.

Es ist die Aufgabe der vorliegenden Erfindung, ein Konzept zu schaffen, mit welchem der Hardware-, Software- bzw. der Qualifizierungsaufwand und somit die Herstellungskosten für Feldgeräte mit sicherheitsgerichteten Ausgängen gesenkt werden können.

Diese Aufgabe wird durch die Merkmale der unabhängigen Patentansprüche gelöst. Vorteilhafte Weiterbildungsformen sind in den nachgeordneten Patentansprüchen beschrieben. Die Erfindung basiert auf der Erkenntnis, dass die Verarbeitungsfunktionen eines Ausgangsmoduls, welches einen Gefährdungspotenzial enthaltenden Aktor steuert, einkanalig ausgeführt und zusätzlich durch ein separates Überwachungsmodul, beispielsweise durch ein Safety-Mastermodul, überwacht werden kann. Stellt das Überwachungsmodul eine Abweichung von erwartetem Verhalten oder eine Unregelmäßigkeit im Verarbeitungsablauf fest, so kann er das gesamte System, welches auch aus mehreren Ausgangsmodulen, beispielsweise aus mehreren Safety-Output-Modulen, bestehen kann, in einen sicheren Zustand überführen. Das Überführen des bzw. der Ausgangsmodule in den sicheren Zustand wird unabhängig von der jeweiligen Verarbeitungseinheit durch einen Hilfskanal realisiert, der den Durchgriff des Überwachungsmoduls ermöglicht und daher im Folgenden als Durchgriffseinrichtung bezeichnet wird.

Somit wird die Sicherheitsfunktion auf das Überwachungsmodul (Safety-Master) und auf das Ausgangsmodul (Safety-Output-Modul) verteilt. Dabei wird der Safety-Master durch den einfachen und preiswerten Abschaltemechanismus der Durchgriffseinrichtung unterstützt. Ferner ist es vorteilhaft für die Funktionsweise des erfindungsgemäßen Konzeptes, den Ausgangsfreigabeimpuls beispielsweise in das Busprotokoll zu integrieren. Durch den Einsatz eines dezentralen Mikroprozessors ist es ferner möglich, die Steuerinformation für das Monoflop, welches einen Ausgang des Ausgangsmoduls bzw. einer geeingneten Ausgabeeinrichtung frei- bzw. abschaltet, zu integrieren. Die Steuerinformation kann beispielsweise zu festen Zeitpunkten in das Datensignal moduliert werden, wodurch eine effiziente Steuerung der Durchgriffseinrichtung möglich ist.

Gemäß einem Aspekt betrifft die Erfindung ein Überwachungssystem mit einem Ausgangsmodul ausgebildet zum Erzeugen eines Steuersignals ansprechend auf ein Eingangssignal, einem Überwachungsmodul ausgebildet zum Erzeugen des Eingangssignals für das Ausgangsmodul, einer Ausgabeeinrichtung ausgebildet zum Ausgeben eines Ausgabesignals ansprechend auf das Steuersignal und einer Durchgriffseinrichtung zum Verhindern bzw. Unterbinden der Ausgabe des Ausgabesignals, wobei das Überwachungsmodul ausgebildet ist, das Steuersignal mit einem auf der Basis des Eingangssignals zu erwartenden Steuersignals zu vergleichen, um das Steuersignal auf ein Vorliegen einer Abweichung zu untersuchen. Das Überwachungsmodul und das Ausgabemodul sind separate Module. Ferner ist das Ausgangsmodul ausgebildet, das Steuersignal an das Überwachungsmodul auszusenden, und das Überwachungsmodul ist ausgebildet, das Steuersignal zu empfangen. Erfindungsgemäß ist das Überwachungsmodul weiterhin ausgebildet, bei Vorliegen einer Abweichung zwischen dem Steuersignal und dem zu erwartenden Steuersignal die Durchgriffseinrichtung anzuweisen, die Ausgabe des Ausgabesignals zu verhindern bzw. unterbinden, wobei die Durchgriffseinrichtung zum Unterbinden des Ausgebens des Ausgabesignals einen Steuer- oder Datenpfad der Ausgabeeinrichtung unterbrechend ausgebildet ist. Die Erfindung sieht weiter vor, dass das Überwachungsmodul ausgebildet ist, ein Freigabesignal zu erzeugen und an das Ausgangsmodul auszusenden, falls das Steuersignal dem zu erwartenden Steuersignal entspricht, wobei das Freigabesignal die Freigabe des Ausgabesignals anzeigt.

Gemäß einer Ausführungsform sind das Überwachungsmodul und das Ausgangsmodul oder die Durchgriffseinrichtung ausgebildet, über ein Kommunikationsnetzwerk, insbesondere über einen Kommunikationsbus, zu kommunizieren.

Gemäß einer Ausführungsform ist die Durchgriffseinrichtung in dem Überwachungsmodul oder in dem Ausgangsmodul angeordnet.

Gemäß einer Ausführungsform umfasst die Ausgabeeinrichtung beispielsweise ein Relais oder eine analoge Ausgangsstufe mit einem Datenpfad zum Empfangen des Steuersignals und einem Energieversorgungspfad zum Versorgen der Ausgabeeinrichtung mit elektrischer Energie. Die analoge Ausgangsstufe kann beispielsweise für einen Bereich zwischen 4mA und 20mA ausgelegt sein, deren Ausgangsstrom bei einem Fehler kleiner als 3mA ist.

Gemäß einer Ausführungsform umfasst die Durchgriffseinrichtung eine monostabile Kippstufe, insbesondere ein Flipflop oder ein Monoflop, wobei die Ausgabeeinrichtung einen Datenpfad und einen Energieversorgungspfad aufweist und wobei ein Ausgang der Kippstufe insbesondere über einen Ausgangstransistor mit dem Datenpfad oder mit dem Energieversorgungspfad zum Einwirken auf den Datenpfad oder auf den Energieversorgungspfad insbesondere ansprechend auf ein an einen Eingang der Kippstufe anlegbares Durchgriffssignal gekoppelt ist.

Gemäß einer Ausführungsform ist die Durchgriffseinrichtung ausgebildet, die Ausgabeeinrichtung ansprechend auf ein Durchgriffssignal in einen Sperrmodus zu überführen.

Gemäß einer Ausführungsform umfasst das Ausgangsmodul einen Mikrocontroller, der vorgesehen ist, das Eingangssignal zu empfangen und das Steuersignal zu erzeugen.

Die Erfindung betrifft ein Verfahren zum Überwachen eines Ausgangsmoduls durch ein Überwachungsmodul, wobei durch das Ausgangsmodul ansprechend auf ein Eingangssignal ein Steuersignal erzeugt und an das Überwachungsmodul ausgesendet wird, wobei durch das Überwachungsmodul das Steuersignal empfangen wird und das Eingangssignals für das Ausgangsmodul erzeugt wird, wobei ansprechend auf das Steuersignal ein Ausgabesignal von einer Ausgabeeinrichtung ausgegeben wird und wobei das Steuersignal durch das Überwachungsmodul mit einem auf der Basis des Eingangssignals zu erwartenden Steuersignal verglichen wird, um das Steuersignal auf ein Vorliegen einer Abweichung hin zu untersuchen. Gemäß der Erfindung wird bei Vorliegen einer Abweichung zwischen dem Steuersignal und dem zu erwartenden Steuersignal eine Durchgriffseinrichtung von dem Überwachungsmodul mittels eines Durchgriffssignals angewiesen, die Ausgabe des Ausgabesignals zu unterbinden, wobei ein Steuer- oder Datenpfad der Ausgabeeinrichtung zum Unterbinden des Ausgebens des Ausgabesignals durch die Durchgriffseinrichtung unterbrochen wird und wobei ein Freigabesignal von dem Überwachungsmodul erzeugt wird und an das Ausgangsmodul ausgesendet wird, falls das Steuersignal dem zu erwartenden Steuersignal entspricht und wobei das Freigabesignal die Freigabe des Ausgabesignals anzeigt. Weitere Schritte des Verfahrens zum Überwachen des Ausgangsmoduls ergeben sich direkt aus der Funktionalität des erfindungsgemäßen Überwachungsmoduls.

Weitere Ausführungsbeispiele der Erfindung werden Bezug nehmend auf die beiliegenden Zeichnungen näher erläutert. Es zeigen:
- Fig. 1: einen prinzipiellen Aufbau eines Überwachungssystems;
- Fig. 2: ein Blockdiagramm eines Überwachungssystems;
- Fig. 3: ein Blockdiagramm eines Ausgangsmoduls;
- Fig. 4: eine Datenrahmenstruktur; und
- Fig. 5: ein Blockdiagramm eines Ausgangsmoduls.

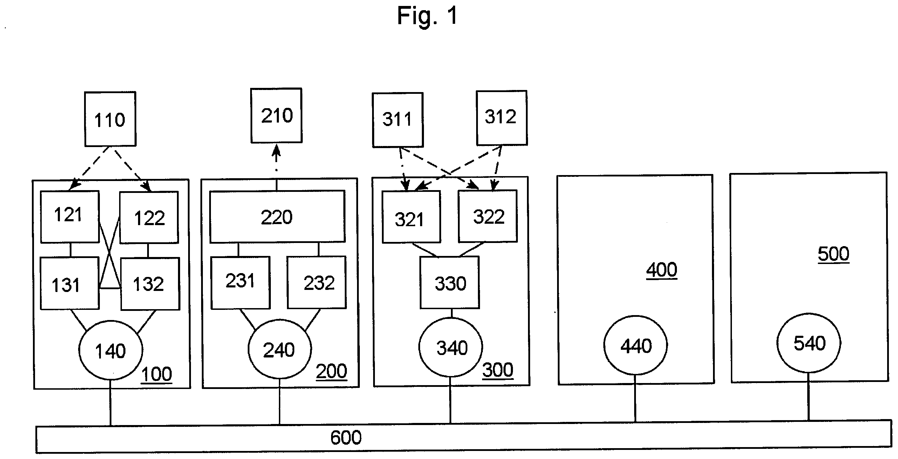

Nachfolgend wird zunächst auf Fig. 1 Bezug genommen, welche einen grundsätzlichen, im Rahmen der Erfindung einsetzbaren Systemaufbau zeigt. Der dargestellte Systemaufbau gestaltet sich topologisch betrachtet als Linie, wobei jedoch auch eine Sterntopologie oder beliebige Mischformen denkbar sind.

Zu sehen sind fünf an einen Bus 600 angeschaltete Bus-Teilnehmer. Ein erster Busteilnehmer ist ein Überwachungsmodul, z.B. ein sicherheitsgerichteter Master, 100, nachfolgend auch als Safety-Master bezeichnet, der im vorliegenden Beispiel gleichzeitig auch der Bus-Master ist, wobei dieses im Rahmen der Erfindung jedoch nicht zwingend ist. Es kann sich hierbei allgemein um einen bestimmten, entsprechend vorgegebenen Sicherheitsteilnehmer handeln. Ein zweiter und dritter Busteilnehmer ist ein sicherheitsgerichteter Slave-Ausgangsteilnehmer 200, nachfolgend auch als Ausgabemodul oder Safety-Output-Slave bezeichnet, bzw. ein sicherheitsgerichteter Slave-Eingangsteilnehmer 300, nachfolgend auch als Safety-Input-Slave bezeichnet. Ein vierter und fünfter Busteilnehmer ist ein nicht sicherheitsgerichteter Slave-Ausgangsteilnehmer 400, nachfolgend auch als Output-Slave bezeichnet, bzw. ein nicht sicherheitsgerichteter Slave-Eingangsteilnehmer 500, nachfolgend auch als Input-Slave bezeichnet. Sicherheitsgerichtete Teilnehmer, d.h. Teilnehmer, welche sicherheitsrelevante Prozessdaten verarbeiten, und nicht sicherheitsgerichtete Teilnehmer können somit gemischt werden und auch beliebig angeordnet sein.

Hinsichtlich der sicherheitsgerichteten Teilnehmer des dargestellten beispielhaften Systemaufbaus ist an den Safety-Master 100 z.B. ein Not-Aus-Schalter 110 angeschaltet, dessen sicherheitsrelevante Eingangsinformation der Teilnehmer 100 über zwei Eingänge 121 und 122 redundant erhält und protokollspezifisch zunächst über zwei redundante Verarbeitungskanäle 131 und 132 verarbeitet, bevor eine Signalankopplung an den Bus 600 erfolgt. An den Safety-Output-Slave 200 ist z.B. ein Motor 210 angeschaltet, wobei der Teilnehmer 200 nach einer Signalauskopplung vom Bus 600 zunächst protokollspezifisch eine Verarbeitung über zwei redundante Verarbeitungskanäle 231 und 232 durchführt und die sicherheitsrelevante Ausgangsinformation an den Motor 210 über einen Ausgang 220 gibt. An den Safety-Input-Slave 300 sind z.B. eine Schutztür 311 und ein Drehzahlgeber 312 angeschaltet, deren sicherheitsrelevante Eingabeinformation der Teilnehmer 300 über zwei Eingänge 321 und 322 redundant erhält und protokollspezifisch über einen Verarbeitungskanal 330 verarbeitet, bevor eine Signalankopplung an den Bus 600 erfolgt.

Die Realisierung einer sicherheitsgerichteten Funktion erfolgt somit in der Regel unter Nutzung einer redundanten Verarbeitung, z.B. durch zwei hardwareseitig von einander getrennte Kanäle, wobei die jeweilige Schnittstelle 140, 240, 340, 440 bzw. 540 eines Teilnehmers zum Bus 600 in der Regel nur einkanalig realisiert ist. Neben einer Reduzierung des benötigten Platzes und der Kosten können hierdurch auch die doppelte Anzahl an Teilnehmern am Bus, insbesondere hinsichtlich Buslast, Stromaufnahme und Kapazität, betrieben werden. Fehler, die durch die Busankopplung, z.B. basierend auf Leitungstreiber, galvanischer Trennung, verursacht werden, können üblicherweise durch das verwendete Leitungsprotokoll erkannt werden. Die Verarbeitungseinheit der sicherheitsgerichteten Teilnehmer muss hardwareseitig jedoch nicht zwangsläufig zweikanalig ausgebildet sein, sondern in vielen Fällen reicht es auch, wenn die Software zweikanalig ausgeführt ist.

Der Bus 600 stellt nunmehr die gemeinsame Datenleitung für das erfindungsgemäße Verfahren und Übertragungssystem zum Senden und Empfangen von allen Daten, insbesondere von Prozessdaten bereit. Beispielsweise basierend auf einem aus der Automobiltechnik bekannten LIN-Bus (LIN: Local Interconnect Network) arbeitet ein derartiges Übertragungssystem, bei welchem während bestimmter Datenzyklen durch einen Master protokollspezifische Daten von über Teilnehmer angeschlossenen Feldgeräten ausgelesen und während jeweils nachfolgender Datenzyklen in solche hineingeschrieben werden können, mit etwa 19,2 bis 38 kbd.

Bei einem beispielhaften Verfahren nach der Erfindung erfolgt die Übertragung von Prozesseingangs- und -ausgangsdaten beispielsweise auch in einem festen Intervall, jeweils um die halbe Buszykluszeit versetzt. Ein Übertragungsprotokoll für beispielsweise eine zyklische Übertragung von Prozesseingangs- und -ausgangsdaten verwendet somit häufig zwei unterschiedliche Datenaustauschdienste, nachfolgend auch als Data-Exchange-Mode bezeichnet. Ein Buszyklus umfasst in diesem Fall folglich einen auf einem PD-Read-Dienst basierten Datenzyklus und einen nachfolgenden Datenzyklus, der auf einem PD-Write-Dienst basiert.

Bei der Übertragung von Prozessausgangsdaten sendet ein Master an die mit diesem verbundenen Teilnehmer beim PD-Write-Dienst grundsätzlich alle Daten für die angeschlossenen Feldgeräte und ermittelt anschließend einen CRC (Cyclic Redundancy Check), den er auch überträgt. Zweckmäßigerweise ist das Übertragungssystem derart ausgebildet, dass alle angeschlossenen Teilnehmer alle so übertragenden Informationen mitlesen und bevorzugt ebenfalls einen CRC bilden, den sie mit dem empfangenen CRC des Masters vergleichen, so dass im Fehlerfall eine Fehlermeldung generiert und beispielsweise ausgewählte Teilnehmer oder einzelne Feldgeräte in einen sicheren Zustand überführt werden. Bei der Übertragung der Prozesseingangsdaten sendet der Master bei einem PD-Read-Dienst z.B. zunächst eine Broadcast-Adresse gefolgt von einem Funktionscode. Die weiteren angeschlossenen Teilnehmer legen daraufhin Daten ihrer angeschalteten Feldgeräte, also insbesondere ihre Prozesseingangsdaten Bit für Bit auf die Datenleitung in jeweils dafür vorgesehene Zeitschlitze. In bevorzugter Ausführung sind die Teilnehmer wiederum in der Lage durch Mithören auf der Datenleitung alle Daten zu erkennen und hierfür wiederum einen CRC zu berechnen.

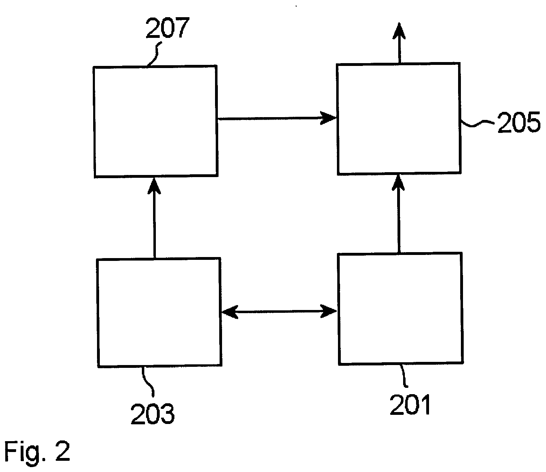

Fig. 2 zeigt ein Blockdiagramm eines Überwachungssystems mit einem Ausgangsmodul 201 und einem Überwachungsmodul 203, das in bidirektionaler Verbindung mit dem Ausgangsmodul 201 steht. Das Überwachungssystem umfasst ferner eine Ausgabeeinrichtung 205, die dem Ausgangsmodul 201 nachgeschaltet ist, sowie eine Durchgriffseinrichtung 207, die dem Überwachungsmodul 203 nachgeschaltet ist und deren Ausgang mit der Ausgabeeinrichtung 205 verbunden ist. Die Ausgabeeinrichtung 205 umfasst einen Ausgang zum Ausgeben eines Ausgabesignals ansprechend auf ein Steuersignal, das das Ausgangsmodul 201 auf der Basis eines durch das Überwachungsmodul 203 zugeleiteten Eingangssignals erzeugt. Zuvor übermittelt das Ausgangsmodul 201 das Steuersignal zwecks Überprüfung an das Überwachungsmodul 203, das dieses auf eine Abweichung von einem zu erwartenden Steuersignal hin überprüft. Liegt eine Abweichung vor, die beispielsweise einen vorgegebenen Schwellwert überschreitet, so weist das Überwachungsmodul 203 die Durchgriffseinrichtung 207 beispielsweise mittels eines Durchgriffssignals an, die Ausgabe des Ausgabesignals zu unterbinden. Dabei wirkt die Durchgriffseinrichtung 207 beispielsweise unmittelbar auf die Ausgabeeinrichtung 205 und unterbricht beispielsweise deren Steuer- bzw. Datenpfad, um die Ausgabe des Ausgabesignals zu unterbinden.

Die Module 201, 203, 205 und 207 müssen nicht zwingend in räumlich getrennten Bauformen realisiert werden. Es ist auch denkbar, dass sie auf einer Leiterplatte realisiert werden. Statt des Bussystems kann ferner zur Kommunikation eine getrennte Verbindung, z.B. über Trennstrecken hinweg, vorgesehen werden.

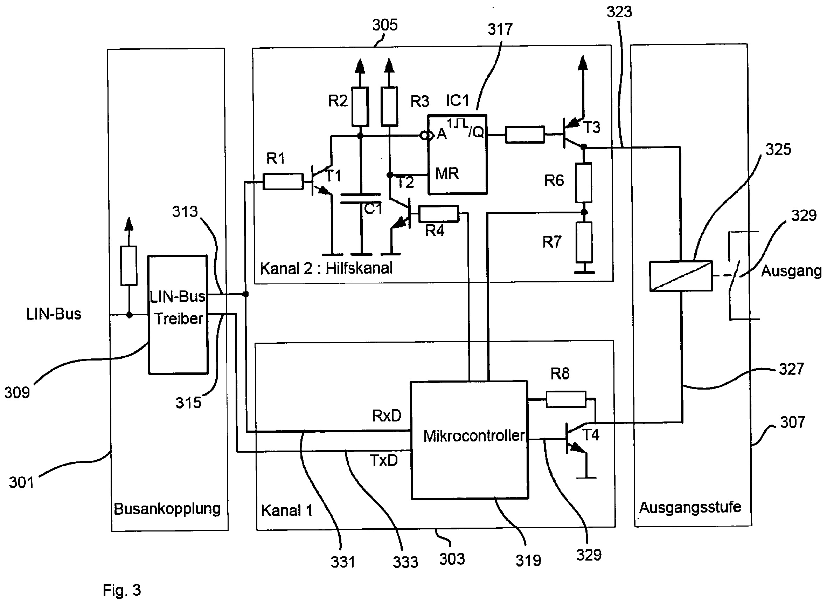

Fig. 3 zeigt ein Ausgangsmodul mit einer Busankopplung 301, einem Mikrocontrollerschaltkreis 303, einer Durchgriffseinrichtung 305 und einer Ausgabeeinrichtung 307. Die Busankopplung 301 umfasst einen Eingang, mit dem beispielsweise ein LIN-Bus koppelbar ist. Der Eingang ist mit einem LIN-Bustreiber 309, der zwei Anschlüsse 313 und 315 aufweist, verbunden. Der Anschluss 313 ist über einen Eingangswiderstand R₁ der Durchgriffseinrichtung 305 mit einem Gate-Anschluss eines Transistors T₁ der Durchgriffseinrichtung 305 verbunden. Der Transistor T₁ hat ferner einen ersten Anschluss, beispielsweise einen Emitteranschluss, der mit Masse verbunden ist. Ein zweiter Anschluss des Transistors T₁, beispielsweise ein Kollektoranschluss, ist mit einem Takteingang A eines Flipflops 317, beispielsweise eines Monoflops, verbunden. Der zweite Ausgang des Transistors T₁ ist über einen Kondensator C₁ mit Masse und über einen Widerstand R₂ mit einem Versorgungspotential verbunden.

Das Flipflop 317 umfasst ferner einen Dateneingang MR, der mit einem zweiten Anschluss, beispielsweise einem Kollektoranschluss, eines zweiten Transistors T₂ verbunden ist. Ein erster Anschluss des Transistors T₂, beispielsweise ein Emitteranschluss, ist hingegen mit Masse verbunden. Der Dateneingang MR ist ferner über einen Widerstand R₃ mit einem Versorgungspotential verbindbar. Ein Gate-Anschluss des Transistors T₂ ist über einen Widerstand R₄ mit einem Anschluss des Mikrocontrollers 319 des Mikrocontrollerschaltkreises 303 verbunden. Ein Ausgang Q des Flipflops 317 ist über einen Widerstand R₅ mit einem Gate-Anschluss eines dritten Transistors T₃ verbunden, dessen erster Anschluss, beispielsweise ein Emitteranschluss, mit einem Versorgungspotential verbindbar ist, und dessen zweiter Anschluss über einen Widerstand R₆ mit einem weiteren Anschluss des Mikrocontrollers 319 verbunden ist. Der Widerstand R₆ ist über einen Widerstand R₇ mit Masse verbunden. Der zweite Anschluss des dritten Transistors T₃ bildet gleichzeitig einen Ausgang 323 der Durchgriffseinrichtung 305, der beispielsweise mit einem Energieversorgungseingang eines Relais 325 der Ausgabeeinrichtung 307 verbunden ist. Das Relais 325 umfasst einen weiteren Pfad 327, bei dem es sich beispielsweise um einen Datenpfad bzw. um einen Steuerungspfad handeln kann. Das Relais 325 ist ferner mit einem Schalter 329 gekoppelt. Der Schalter 329 überbrückt in Abhängigkeit von einem Relaiszustand zwei Kontakte, wobei nur im geschlossenen Schalterzustand ein Ausgabesignal ausgegeben werden kann.

Der Datenpfad 327 des Relais 325 ist mit einem zweiten Anschluss eines Transistors T₄ verbunden, beispielsweise mit einem Kollektoranschluss. Der Transistor T₄ umfasst ferner einen zweiten Anschluss, beispielsweise einen Emitteranschluss, der mit Masse verbunden ist. Dabei ist ein Ausgang 329 des Mikrocontrollers 319 mit einem Gate des Transistors T₄ verbunden. Ein weiterer Anschluss des Mikrocontrollers 319 ist ferner über einen Widerstand R₈ mit dem zweiten Anschluss des Transistors T₄ verbunden.

Der Anschluss 313 des Bustreibers 309 ist ferner mit einem Eingangsanschluss 331 des Mikrocontrollers 319 verbunden. Ein Ausgangsanschluss 333 des Mikrocontrollers ist hingegen mit dem Anschluss 315 verbunden. Der Mikrocontroller 319 empfängt Daten, beispielsweise ein Eingangssignal, über den Eingangsanschluss 331 von einem in Fig. 3 nicht dargestellten Überwachungsmodul und erzeugt auf dessen Basis ein Steuersignal, das beispielsweise über den Datenpfad 327 dem Relais 325 zugeleitet wird. Zuvor übersendet der Mikrocontroller 319 jedoch über den Ausgangsanschluss 333 das Steuersignal an das nicht dargestellte Überwachungsmodul. Das Überwachungsmodul überprüft, ob das Steuersignal einem beispielsweise auf der Basis des Eingangssignals, d.h. der Eingangsdaten, zu erwartenden Steuersignal entspricht. Bei einer Abweichung, die beispielsweise einen Schwellwert überschreitet, übermittelt das Überwachungsmodul der Durchgriffseinrichtung 305 über den Anschluss 313 des Treibers 309 beispielsweise ein Durchgriffssignal, auf dessen Basis beispielsweise, alternativ zur vorliegenden Erfindung, die Energieversorgung des Relais 325 unterbrochen wird, wodurch die Schließung des Schalters 329 verhindert bzw. unterbunden wird. Dadurch wird die Ausgabe des Ausgabesignals unterbunden.

Das der Struktur des in Fig. 3 dargestellten Ausgangsmoduls zugrunde liegende Konzept ist zweikanalig. Der erste Kanal wird dabei durch die Mikrocontrollerschaltung 303 gebildet, während die Durchgriffseinrichtung 305 als ein zweiter Kanal, beispielsweise als ein Hilfskanal, verstanden werden kann. Dabei ist der Kanal 2, also die Durchgriffseinrichtung 305, des Ausgangsmoduls nicht notwendigerweise als ein vollwertiger Kanal ausgeführt. Die eigentliche Sicherheitsfunktion wird beispielsweise durch den Mikrocontroller 319 der Mikrocontrollerschaltung 303 realisiert. Der Mikrocontroller 319 kann ferner vorgesehen sein, die funktionale Implementierung des Busprotokolls zu realisieren, wobei die physikalische Busankopplung beispielsweise durch den in Fig. 3 dargestellten LIN-Bustreiber 309 hergestellt werden kann.

Nachdem beispielsweise ein Protokollframe korrekt empfangen wurde und alle PDCs (PDC: Process Data Channel) die Plausibilitätsüberprüfungen absolviert haben, kann die Abarbeitung der Sicherheitsfunktion mit den empfangenen Daten beginnen. Dabei steuert der Mikrocontroller 329 durch den Transistor T₄ die Ausgabeeinrichtung 307 (Ausgangsstufe), welche exemplarisch ein Relais aufweisen kann. Der Widerstand R₈ dient dabei zur Überwachung der Ausgangsstufe 307, wobei ein Überwachungsergebnis mittels des Mikrocontrollers 319 im nächsten Datenzyklus als Sicherheits-PDC (Safety-PDC) veröffentlicht wird. Das in Fig. 3 nicht dargestellte Überwachungsmodul ist aufgrund der bekannten Sicherheitsfunktionen sowie der Eingangsdaten bzw. der Eingangssignale in der Lage, den Mikrocontroller 319 und seinen Ausgang zu überprüfen. Wird eine Abweichung festgestellt, so schaltet das Überwachungsmodul durch den mittels der Durchgriffseinrichtung 305 realisierten überlagerten Sicherungsmechanismus das System in einen sicheren Zustand.

Alternativ zum dargestellten Relais kann z.B. auch eine analoge Ausgangsstufe eingesetzt werden, die beispielsweise für einen Bereich zwischen 4mA und 20mA ausgelegt ist, wobei deren Ausgangsstrom bei einem Fehler kleiner als 3mA ist.

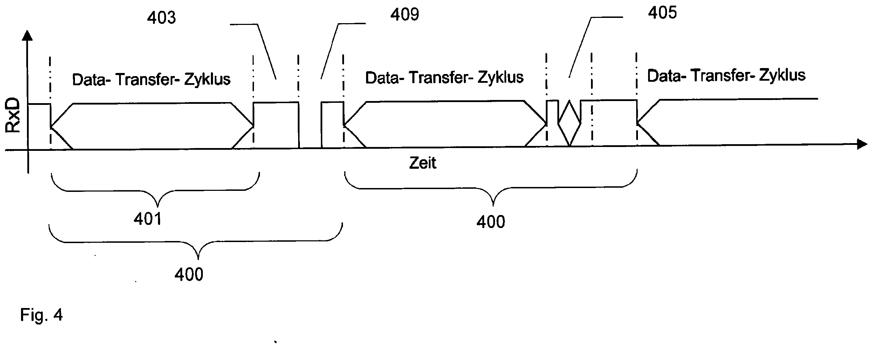

Fig. 4 zeigt exemplarisch ein Bus-Timing mit einem Übertragungszyklus 400, der in drei Phasen eingeteilt werden kann. In der ersten Phase 401 werden Nutzdaten übertragen. Die zweite Phase 403 dient der Datenüberprüfung auf Frame- und PDC-Ebene. Wird beispielsweise von keinem der Teilnehmer ein Fehler entdeckt, so verbleibt das Datensignal des LIN-Busses im Hochpegelzustand, der einem "High" entspricht. Wird ein Fehler detektiert, so sendet der betreffende Teilnehmer einen Fehlercode, wie es anhand des Datenabschnitts 405 dargestellt ist. Falls im gesamten Übertragungs- und Verarbeitungszyklus inklusive der Überprüfung der Ausgangszustände der Sicherheitsausgänge kein Fehler erkannt wurde, so erzeugt das Überwachungsmodul, also der Master, ein Freigabesignal für die Ausgänge, welches durch das Monoflop 317 aus Fig. 3 ausgewertet wird. Die Datenüberprüfung findet beispielsweise in Abschnitt 403 statt. Die Ausgangsfreigabe ist dabei durch den Abschnitt 409 angedeutet.

Das Monoflop 317 (IC 1) ist beispielsweise retriggerbar mit einer Monozeit von 30 ms. Es kann beispielsweise nur dann getriggert werden, wenn das Bussignal für beispielsweise mindestens 700 µs einen Niederpegelzustand, sog. "Low", dargestellt durch die Ausgangsfreigabe 409, annimmt. Während einer Datenübertragung mit einer Baudrate von mindestens 14400 Baud ist dieses jedoch nicht gewährleistet, weil durch die Übertragung eines Stopp-Bits am Ende jedes Zeichens mindestens eine logische "1" erzwungen wird. Der Ruhepegel des LIN-Busses ist ebenfalls logisch "1", so dass eine längere Businaktivität zu keiner Triggerung führt.

Der "1"-Pegel auf dem LIN-Bus führt dazu, dass der in Fig. 3 dargestellte Transistor T₁ durchgeschaltet wird, was ein Aufladen des Kondensators C₁ verhindert bzw. unterbunden, so dass keine negative Flanke am Eingang des Monoflops 317 auftreten kann. Erst ein logisches "Low" sperrt den Transistor und führt dazu, dass der Kondensator C₁ durch den Widerstand R₂ geladen wird. Nach etwa 700 µs ist der Kondensator C₁ bis beispielsweise über den "High"-Schaltpegel des Monoflops 317 geladen, so dass mit einem Wechsel des LIN-Bus-Signals von "Low" nach "High" eine triggernde Flanke am Monoflop 317 erzeugt wird. Anschließend wird der Ausgang /Q auf "Low" geschaltet, was zu einer Freigabe der Ausgangsstufe 307 führt. Durch den Widerstand R₈ kann der Mikrocontroller den Schalttransistor T₄ überprüfen. Der Spannungsteiler umfassend die Widerstände R₆ und R₇ dient zur Überprüfung der Durchgriffseinrichtung 305, die beispielsweise als ein Hilfskanal realisiert ist. Für die Überprüfung kann es vorteilhaft sein, das Monoflop 317 über den Transistor T₂ zurückzusetzen, was zu einem Sperren des Transistors T₃ und damit zu einem Abschalten der Ausgangsstufe 307 führt.

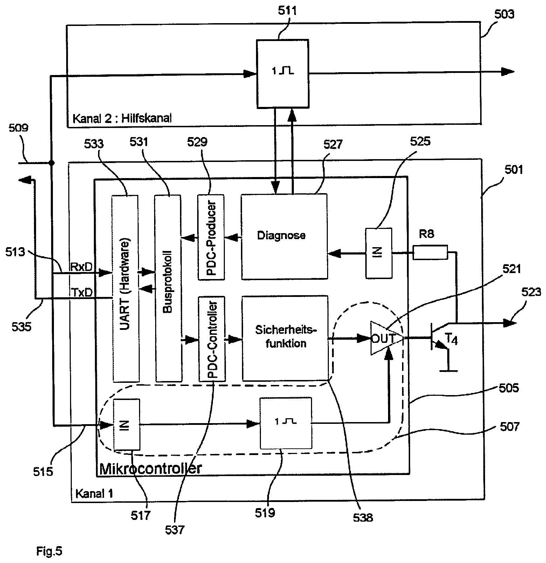

Fig. 5 zeigt ein Blockdiagramm eines Ausgangsmoduls mit einer Mikrocontrollerschaltung 501 und einer Durchgriffseinrichtung 503. Die Mikrocontrollerschaltung 501 umfasst einen Mikrocontroller 505 mit einer weiteren Durchgriffseinrichtung 507. Ein Eingang 509 des Ausgangsmoduls ist mit einem Flipflop 511, beispielsweise mit einem Monoflop, der Durchgriffseinrichtung 503 verbunden. Das Flipflop 511 hat ferner einen Ausgang, der beispielsweise mit einer in Fig. 5 nicht dargestellten Ausgabeeinrichtung koppelbar ist.

Der Eingang 509 ist ferner mit einem Empfangseingang 513 des Mikrocontrollers 505 sowie mit einem Eingang 515 der weiteren Durchgriffseinrichtung 507 verbunden. Diese umfasst ein Eingangsbauelement 517, das mit einem Eingang eines Flipflops 519, beispielsweise eines Monoflops, verbunden ist. Ein Ausgang des Flipflops 519 ist mit einem Anschluss eines Ausgangstreibers 521, beispielsweise eines Operationsverstärkers, der weiteren Durchgriffseinrichtung 507 verbunden. Ein Ausgang des Ausgangstreibers 521 ist mit einem Gate eines Transistors T₄ verbunden, dessen erster Anschluss, beispielsweise ein Kollektoranschluss, einen Ausgang 523 der Mikrocontrollerschaltung 501 bildet. Ein zweiter Anschluss des Transistors T₄, beispielsweise ein Kollektoranschluss, ist hingegen mit Masse verbunden. Der zweite Anschluss des Transistors T₄ ist über einen Widerstand R₈ mittels einer Rückkopplung mit einem Eingangselement 525, beispielsweise einem Eingangstreiber, des Mikrocontrollers 505 verbunden. Ein Ausgang des Eingangselementes 525 ist mit einem Diagnoseelement 527 verbunden, das wie in Fig. 5 dargestellt mit dem Flipflop 511 verbunden ist. Ein Ausgang des Diagnoseelementes 527 ist mit einem PDC-Producer 529 verbunden, dessen Ausgang mit einem Buselement 531 verbunden ist. Das Buselement 531 ist ferner mit einem UART 533 gekoppelt (UART: Universal Asynchronous Receiver/Transmitter). Wie in Fig. 5 dargestellt ist der Empfangseingang 513 mit einem Eingang des UARTs 533 verbunden. Der UART 533 hat ferner einen Ausgang 535, der einen Ausgang der Mikrocontrollerschaltung 501 bildet. Das Busprotokollelement 531 ist mit einem PDC-Consumer 537 gekoppelt, dessen Ausgang mit einem Sicherheitsfunktionsblock 538 verbunden ist. Der Sicherheitsfunktionsblock 538 hat einen Ausgang, der mit einem Eingang des Ausgangselementes 521 verbunden ist.

Die weitere Durchgriffseinrichtung 507 kann beispielsweise in Software realisiert werden, während die Durchgriffseinrichtung 503 in Hardware realisiert werden kann. Weitere in Hardware realisierte Komponenten können das UART-Element 533 sowie die Eingangselemente 517, 525 und das Ausgangselement 521 sein. Die Elemente 527, 529, 531, 537, 519 sowie 538 können hingegen in Software realisiert sein.

Der Hauptsignalpfad der Sicherheitsfunktion führt von dem UART-Block 533 durch einen Protokoll-Stack, der in dem Busprotokollelement 531 realisiert ist. Der Datenaustausch zwischen dem Busprotokoll und der Verarbeitungseinheit geschieht beispielsweise mittels zwei Buffer 529 und 537, wobei die Eingangsdaten der Sicherheitsfunktion im Consumer-PDC-Buffer 537 gespeichert werden. Dementsprechend werden die Ausgangs- und die Statusdaten durch den Producer-Buffer 529 zu einem Überwachungsmodul, das in Fig. 5 nicht dargestellt ist, übertragen.

Der Ausgangstreiber 521 des Mikrocontrollers 505 hat, wie in Fig. 5 dargestellt, zwei Eingänge, wobei die Sicherheitsfunktion beispielsweise nur den Daten- bzw Steuereingang verwendet. Sofern der Ausgangstreiber 521 durch den zweiten Eingang freigeschaltet ist, wird dieser Zustand für den Transistor T₄ sichtbar. Das Monoflop 519 realisiert beispielsweise die gleiche Funktion wie die Durchgriffseinrichtung 503, die auch als ein zweiter Kanal oder als ein Hilfskanal bezeichnet werden kann, mit dem Unterschied, dass er nahezu komplett in Software implementiert sein kann und damit für Diversität sorgt.

Alternativ zu dem in Fig. 5 dargestellten Ausführungsbeispiel kann auch die Durchgriffseinrichtung 503 sowie deren Monoflopfunktion durch eine Softwarefunktion realisiert werden. Dies ist insbesondere dann von Vorteil, wenn bei komplexeren Ausgangsmodulen ein zweiter Mikrocontroller eingesetzt wird.

## Patentansprüche

1. Überwachungssystem, mit:
einem Ausgangsmodul (201) ausgebildet zum Erzeugen eines Steuersignals ansprechend auf ein Eingangssignal;
einem Überwachungsmodul (203) ausgebildet zum Erzeugen des Eingangssignals für das Ausgangsmodul (201), wobei das Überwachungsmodul (203) und das Ausgangsmodul (201) separate Module sind;
einer Ausgabeeinrichtung (205) ausgebildet zum Ausgeben eines Ausgabesignals ansprechend auf das Steuersignal; und
einer Durchgriffseinrichtung (207) zum Unterbinden der Ausgabe des Ausgabesignals;
wobei das Ausgangsmodul (201) ausgebildet ist, das Steuersignal an das Überwachungsmodul (203) auszusenden, und das Überwachungsmodul (203) ausgebildet ist, das Steuersignal zu empfangen;
wobei das Überwachungsmodul (203) ausgebildet ist, das Steuersignal mit einem auf der Basis des Eingangssignals zu erwartenden Steuersignal zu vergleichen, um das Steuersignal auf ein Vorliegen einer Abweichung hin zu untersuchen,
**dadurch gekennzeichnet, dass** das Überwachungsmodul (203) ausgebildet ist, bei Vorliegen einer Abweichung zwischen dem Steuersignal und dem zu erwartenden Steuersignal die Durchgriffseinrichtung (207) durch Aussendung eines Durchgriffssignals an die Durchgriffseinrichtung (207) anzuweisen, die Ausgabe des Ausgabesignals zu unterbinden, wobei die Durchgriffseinrichtung (207) zum Unterbinden des Ausgebens des Ausgabesignals einen Steuer- oder Datenpfad der Ausgabeeinrichtung (205) unterbrechend ausgebildet ist, und wobei das Überwachungsmodul (203) ausgebildet ist, ein Freigabesignal zu erzeugen und an das Ausgangsmodul (201) auszusenden, falls das Steuersignal dem zu erwartenden Steuersignal entspricht, wobei das Freigabesignal die Freigabe des Ausgabesignals anzeigt.

2. Überwachungssystem gemäß Anspruch 1, wobei das Überwachungsmodul (203) und das Ausgangsmodul (201) oder die Durchgriffseinrichtung (207) ausgebildet sind, über ein Kommunikationsnetzwerk, insbesondere über einen Kommunikationsbus, zu kommunizieren.

3. Überwachungssystem gemäß einem der vorstehenden Ansprüche, wobei die Durchgriffseinrichtung (207) in dem Überwachungsmodul (203) oder in dem Ausgangsmodul (201) angeordnet ist.

4. Überwachungssystem gemäß einem der vorstehenden Ansprüche, wobei die Ausgabeeinrichtung (205) ein Relais oder eine analoge Ausgangsstufe mit einem Datenpfad zum Empfangen des Steuersignals und einem Energieversorgungspfad zum Versorgen der Ausgabeeinrichtung mit elektrischer Energie aufweist.

5. Überwachungssystem gemäß einem der vorstehenden Ansprüche, wobei die Durchgriffseinrichtung (207) eine monostabile Kippstufe, insbesondere ein Flipflop oder einen Monoflop, aufweist, wobei die Ausgabeeinrichtung (205) einen Datenpfad und einen Energieversorgungspfad aufweist und wobei ein Ausgang der Kippstufe insbesondere über einen Ausgangstransistor mit dem Datenpfad zum Einwirken auf den Datenpfad insbesondere ansprechend auf ein an einen Eingang der Kippstufe anlegbares Durchgriffssignal gekoppelt ist.

6. Überwachungssystem gemäß einem der vorstehenden Ansprüche, wobei die Durchgriffseinrichtung (207) ausgebildet ist, die Ausgabeeinrichtung (205) ansprechend auf ein Durchgriffssignal in einen Sperrmodus zu überführen.

7. Überwachungssystem gemäß einem der vorstehenden Ansprüche, wobei das Ausgangsmodul (201) einen Mikrocontroller aufweist, der vorgesehen ist, das Eingangssignal zu empfangen und das Steuersignal zu erzeugen.

8. Verfahren zum Überwachen eines Ausgangsmoduls (201) durch ein separates Überwachungsmodul (203), wobei durch das Ausgangsmodul (201) ansprechend auf ein Eingangssignal ein Steuersignal erzeugt und an das Überwachungsmodul (203) ausgesendet wird, wobei durch das Überwachungsmodul (203) das Steuersignal empfangen wird und das Eingangssignal für das Ausgangsmodul (201) erzeugt wird, wobei ansprechend auf das Steuersignal ein Ausgabesignal von einer Ausgabeeinrichtung (205) ausgegeben wird, und
wobei das Steuersignal durch das Überwachungsmodul (203) mit einem auf der Basis des Eingangssignals zu erwartenden Steuersignal verglichen wird, um das Steuersignal auf ein Vorliegen einer Abweichung hin zu untersuchen,
**dadurch gekennzeichnet, dass**
bei Vorliegen einer Abweichung zwischen dem Steuersignal und dem zu erwartenden Steuersignal eine Durchgriffseinrichtung (207) von dem Überwachungsmodul (203) mittels eines Durchgriffssignals angewiesen wird, die Ausgabe des Ausgabesignals zu unterbinden, und wobei ein Steuer- oder Datenpfad der Ausgabeeinrichtung (205) zum Unterbinden des Ausgebens des Ausgabesignals durch die Durchgriffseinrichtung (207) unterbrochen wird und wobei ein Freigabesignal von dem Überwachungsmodul (203) erzeugt wird und an das Ausgangsmodul (201) ausgesendet wird, falls das Steuersignal dem zu erwartenden Steuersignal entspricht und wobei das Freigabesignal die Freigabe des Ausgabesignals anzeigt.

## Claims

1. A monitoring system, comprising:
an output module (201) adapted to generate a control signal in response to an input signal; a monitoring module (203) adapted to generate the input signal for the output module (201),
the monitoring module (203) and the output module (201) being separate modules;
an output device (205) adapted to output an output signal in response to the control signal; and
a crack-down device (207) for inhibiting the output of the output signal;
wherein the output module (201) is adapted to transmit the control signal to the monitoring module (203), and the monitoring module (203) is adapted to receive the control signal;
wherein the monitoring module (203) is adapted to compare the control signal with a control signal to be expected on the basis of the input signal in order to check the control signal for the presence of a discrepancy;
**characterized in that**
in the presence of a discrepancy between the control signal and the expected control signal, the monitoring module (203) is adapted to instruct the crack-down device (207) to inhibit the output of the output signal, by sending a crack-down signal to the crack-down device (207);
wherein the crack-down device (207) is adapted to interrupt a control or data path of the output device (205) to inhibit the output of the output signal; and
if the control signal corresponds to the expected control signal, the monitoring module (203) is adapted to generate an release signal and to transmit it to the output module (201), wherein the release signal indicates the release of the output signal.

2. The monitoring system according to claim 1, wherein the monitoring module (203) and the output module (201) or the crack-down device (207) are adapted to communicate via a communication network, in particular via a communication bus.

3. The monitoring system according to any one of the preceding claims, wherein the crack-down device (207) is provided in the monitoring module (203) or in the output module (201).

4. The monitoring system according to any one of the preceding claims, wherein the output device (205) includes a relay or an analog output stage including a data path for receiving the control signal and including an power supply path for supplying electrical power to the output device.

5. The monitoring system according to any one of the preceding claims, wherein the crack-down device (207) includes a monostable multivibrator, in particular a flip-flop or a monoflop, wherein the output device (205) includes a data path and a power supply path, and wherein an output of the multivibrator is coupled to the data path, in particular via an output transistor, for acting on the data path in particular in response to a crack-down signal that can be applied to an input of the multivibrator.

6. The monitoring system according to any one of the preceding claims, wherein the crack-down device (207) is adapted to transfer the output device (205) into a blocked mode in response to a crack-down signal.

7. The monitoring system according to any one of the preceding claims, wherein the output module (201) includes a microcontroller that is intended for receiving the input signal and for generating the control signal.

8. A method for monitoring an output module (201) by a separate monitoring module (203),
wherein a control signal is generated by the output module (201) in response to an input signal and is transmitted to the monitoring module (203), wherein the monitoring module (203) receives the control signal and generates the input signal for the output module (201), wherein in response to the control signal an output signal is output by an output device (205), and wherein the control signal is compared with a control signal to be expected on the basis of the input signal, by the monitoring module (203), in order to check the control signal for the presence of a discrepancy;
**characterized in that**
in the presence of a discrepancy between the control signal and the expected control signal, the monitoring module (203) instructs a crack-down device (207) to inhibit the output of the output signal, by means of a crack-down signal, and wherein, for inhibiting the output of the output signal, a control or data path of the output device (205) is interrupted by the crack-down device (207); and if the control signal corresponds to the expected control signal, a release signal is generated by the monitoring module (203) and is transmitted to the output module (201), and wherein the release signal indicates the release of the output signal.

## Revendications

1. Système de surveillance comprenant :
un module de sortie (201) conçu pour générer un signal de commande en réponse à un signal d'entrée ;
un module de surveillance (203) conçu pour générer le signal d'entrée pour le module de sortie (201), où le module de surveillance (203) et le module de sortie (201) sont des modules séparés ;
un dispositif d'émission (205) conçu pour l'émission d'un signal de sortie en réponse au signal de commande ; et
un dispositif de passage (207) pour interdire l'émission du signal de sortie ;
dans lequel le module de sortie (201) est conçu pour envoyer le signal de commande au module de surveillance (203) et le module de surveillance (203) est conçu pour recevoir le signal de commande ;
dans lequel le module de surveillance (203) est conçu pour comparer le signal de commande avec un signal de commande attendu en fonction du signal d'entrée afin d'examiner le signal de commande et de détecter l'existence d'un écart,
**caractérisé en ce que**
le module de surveillance (203) est conçu, lors de l'existence d'un écart entre le signal de commande et le signal de commande attendu, pour ordonner au dispositif de passage (207), par l'envoi d'un signal de passage au dispositif de passage (207), d'interdire l'émission du signal de sortie, où le dispositif de passage (207) est conçu pour interdire l'émission du signal de sortie en interrompant un chemin de commande ou de données du dispositif d'émission (205), et où le module de surveillance (203) est conçu pour générer un signal de validation et pour l'envoyer au module de sortie (201) au cas où le signal de commande correspond au signal de commande attendu, où le signal de validation indique la validation du signal de sortie.

2. Système de surveillance selon la revendication 1, dans lequel le module de surveillance (203) et le module de sortie (201) ou le dispositif de passage (207) sont conçus pour communiquer par l'intermédiaire d'un réseau de communication, plus particulièrement par l'intermédiaire d'un bus de communication.

3. Système de surveillance selon l'une des revendications précédentes, dans lequel le dispositif de passage (207) est disposé dans le module de surveillance (203) ou dans le module de sortie (201) .

4. Système de surveillance selon l'une des revendications précédentes, dans lequel le dispositif d'émission (205) comprend un relais ou un étage de sortie analogique avec un chemin de données pour la réception du signal de commande et un chemin d'alimentation en énergie pour l'alimentation du dispositif d'émission en énergie électrique.

5. Système de surveillance selon l'une des revendications précédentes, dans lequel le dispositif de passage (207) comprend un étage à bascule monostable, plus particulièrement une bascule ou une bascule monostable, dans lequel le dispositif d'émission (205) comprend un chemin de données et un chemin d'alimentation en énergie et dans lequel une sortie de l'étage à bascule est couplée, plus particulièrement par l'intermédiaire d'un transistor de sortie, avec le chemin de données, afin d'agir sur le chemin de données, plus particulièrement en réponse à un signal de passage pouvant être appliqué à une entrée de l'étage à bascule.

6. Système de surveillance selon l'une des revendications précédentes, dans lequel le dispositif de passage (207) est conçu pour mettre le dispositif d'émission (205) dans un mode de blocage en réponse à un signal de passage.

7. Système de surveillance selon l'une des revendications précédentes, dans lequel le module de sortie (201) comprend un micro-contrôleur qui est conçu pour recevoir le signal d'entrée et générer le signal de commande.

8. Procédé de surveillance d'un module de sortie (201) par un module de surveillance (203) séparé, dans lequel le module de sortie (201) génère un signal de commande en réponse à un signal d'entrée et l'envoie au module de surveillance (203), dans lequel le module de surveillance (203) reçoit le signal de commande et génère le signal d'entrée pour le module de sortie (201), dans lequel, en réponse au signal de commande, un signal de sortie est émis par un dispositif d'émission (205), et dans lequel le signal de commande est comparé, par le module de surveillance (203), avec un signal de commande attendu en fonction du signal d'entrée, afin d'examiner le signal de commande et de détecter l'existence d'un écart,
**caractérisé en ce que**
lors de l'existence d'un écart entre le signal de commande et le signal de commande attendu, il est ordonné à un dispositif de passage (207), par le module de surveillance (203), au moyen d'un signal de passage, d'interdire l'émission du signal de sortie, et dans lequel un chemin de commande ou de données du dispositif d'émission (205) est interrompu par le dispositif de passage (207) afin d'interdire l'émission du signal de sortie et dans lequel un signal de validation est généré par le module de surveillance (203) et envoyé au module de sortie (201), dans le cas où le signal de commande correspond au signal de commande attendu et dans lequel le signal de validation indique la validation du signal de sortie.
